(19) **Europäisches Patentamt / European Patent Office / Office européen des brevets**

(11) **EP 4 741 340 A1**

(12) **EUROPEAN PATENT APPLICATION**
published in accordance with Art. 153(4) EPC

(43) Date of publication:
**13.05.2026 Bulletin 2026/20**

(21) Application number: **24839400.9**

(22) Date of filing: **13.06.2024**

(51) International Patent Classification (IPC):
$C01B\ 32/158^{(2017.01)}$    $C01B\ 32/16^{(2017.01)}$
$C01B\ 32/174^{(2017.01)}$    $H01M\ 4/13^{(2010.01)}$
$H01M\ 4/62^{(2006.01)}$

(52) Cooperative Patent Classification (CPC):
Y02E 60/10

(86) International application number:
**PCT/JP2024/021495**

(87) International publication number:
**WO 2025/013504 (16.01.2025 Gazette 2025/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.07.2023 JP 2023112648**
**29.03.2024 JP 2024058118**

(71) Applicant: **Sumitomo Chemical Company, Limited Tokyo 103-6020 (JP)**

(72) Inventors:
• **ARIMURA, Takashi**
**Tsukuba-shi, Ibaraki 300-3294 (JP)**
• **AKATSU, Mitsutoshi**
**Tsukuba-shi, Ibaraki 300-3294 (JP)**
• **YASHIRO, Arihiro**
**Tsukuba-shi, Ibaraki 300-3294 (JP)**

(74) Representative: **J A Kemp LLP**
**80 Turnmill Street**
**London EC1M 5QU (GB)**

(54) **MULTILAYER CARBON NANOTUBE ASSEMBLY, MULTILAYER CARBON NANOTUBE DISPERSION LIQUID, CONDUCTIVE MATERIAL, ELECTRODE, SECONDARY BATTERY, PLANAR ASSEMBLY, FILTER, ELECTROMAGNETIC WAVE SHIELD, AND PELLICLE FOR EXTREME ULTRAVIOLET RAYS**

(57) Provided are a multi-walled carbon nanotube assembly having high conductivity and good dispersibility in a dispersion medium, as well as a multi-walled carbon nanotube dispersion liquid, a conductive material, an electrode, a secondary battery, a planar assembly, a filter, an electromagnetic wave shielding, and a pellicle for extreme ultraviolet rays.

A multi-walled carbon nanotube assembly, containing multi-walled carbon nanotubes having a maximum length of 1,000 μm to 30,000 μm, and Fe atoms, in which the content ratio of Fe atoms to a total mass of the assembly is 0.5 mass% or more and less than 10 mass%; as well as a multi-walled carbon nanotube dispersion liquid, a conductive material, an electrode, a secondary battery, a planar assembly, a filter, an electromagnetic wave shielding, and a pellicle for extreme ultraviolet rays.

EP 4 741 340 A1

**Description**

Technical Field

The present disclosure relates to a multi-walled carbon nanotube assembly, a multi-walled carbon nanotube dispersion liquid, a conductive material, an electrode, a secondary battery, a planar assembly, a filter, an electromagnetic wave shielding, and a pellicle for extreme ultraviolet rays.

Background Art

Carbon nanotubes have good mechanical and electronic characteristics, and are expected to be used for various purposes.

As carbon nanotubes (which may be hereinafter referred to as "CNT"), single-walled carbon nanotubes (which may be hereinafter referred to as "SWCNT") and multi-walled carbon nanotubes (which may be hereinafter referred to as "MWCNT") that are several $\mu$m to several tens of $\mu$m in length are known.

SWCNT is a seamless cylindrical tube formed from a single layer of graphene, has a high specific surface area, thus can be expected to have high conductivity, and therefore attracts attention as a conductive auxiliary agent.

On the other hand, MWCNT is formed such that a plurality of layers of concentric cylindrical tubes overlap one another. Some MWCNT has as many as several tens of layers.

MWCNT is larger in diameter of the cylindrical tube than SWCNT and smaller in specific surface area than SWCNT, and therefore has slightly better handleability over SWCNT, but has a problem that it is difficult to exhibit conductivity as high as that of SWCNT.

CNT that is several $\mu$m to several tens of $\mu$m in length is powdery, and is mainly composed of carbon. Therefore, CNT is typically difficult to handle, and has poor dispersibility in a dispersion medium.

In recent years, longer CNT, specifically long-fiber MWCNT having a length in the order of several mm, has attracted attention. Long-fiber MWCNT has a low specific surface area, but is expected to have higher conductivity over short MWCNT because of the large length. Long-fiber MWCNT is easier to handle over powdery CNT.

Long fiber MWCNT has been heretofore difficult to produce, but is expected to be more easily obtained by virtue of recent studies made on production techniques.

For example, a method has been proposed in which a plurality of CNT is collected in a state of being aligned in a longitudinal direction, thereby obtaining an elongated CNT assembled line or CNT assembled line bundle (see, for example, Patent Literature 1). Patent Literature 1 discloses a technique capable of setting the length of a CNT assembled line to 10 cm or more.

Citation List

Patent Literature

Patent Literature 1: International Publication No. WO 2020/138379

Summary of Invention

Problems to be Solved by Invention

A CNT assembly obtained by the technique disclosed in Patent Literature 1 includes an assembly of long fibers in which CNT fibers are aligned. Patent Literature 1 does not describe the dispersibility in a dispersion medium, which is important for the application of CNT.

A problem to be solved by an embodiment of the present disclosure is to provide a multi-walled carbon nanotube assembly having high conductivity and good dispersibility in a dispersion medium, as well as a conductive material, an electrode, a secondary battery, and a planar assembly, each containing the multi-walled carbon nanotube assembly.

A problem to be solved by another embodiment of the present disclosure is to provide a multi-walled carbon nanotube dispersion liquid containing a multi-walled carbon nanotube assembly having high conductivity.

A problem to be solved by yet another embodiment of the present disclosure is to provide a planar assembly containing multi-walled carbon nanotube powder, and a filter, an electromagnetic wave shielding, and a pellicle for extreme ultraviolet rays, each including the planar assembly.

Means to Solve the Problems

<1> A multi-walled carbon nanotube assembly comprising: multi-walled carbon nanotubes having a maximum length of 1,000 μm to 30,000 μm; and Fe atoms, wherein a content ratio of Fe atoms to a total mass of the assembly is 0.5 mass% or more and less than 10 mass%.

<2> The multi-walled carbon nanotube assembly according to <1>, which is a conductive auxiliary agent.

<3> A multi-walled carbon nanotube dispersion liquid comprising the multi-walled carbon nanotube assembly according to <1> or <2>, and a dispersion medium.

<4> A conductive material comprising the multi-walled carbon nanotube assembly according to <1> or <2>.

<5> The multi-walled carbon nanotube dispersion liquid according to <3>, which is an ink composition for formation of a lithium battery negative electrode.

<6> An electrode comprising an electrode active material, and the conductive material according to <4>.

<7> A secondary battery comprising the electrode according to <6>.

<8> A composition comprising the multi-walled carbon nanotube assembly according to <1> or <2>, and at least one selected from the group consisting of a resin, a ceramic, and concrete.

<9> A multi-walled carbon nanotube assembly comprising: multi-walled carbon nanotubes having a tensile strength of 10 MPa to 100 MPa; and Fe atoms, wherein a content ratio of Fe atoms to a total mass of the assembly is 0.5 mass% or more and less than 10 mass%.

<10> The multi-walled carbon nanotube assembly according to <9>, which is a conductive auxiliary agent.

<11> A multi-walled carbon nanotube dispersion liquid comprising the multi-walled carbon nanotube assembly according to <9> or <10>, and a dispersion medium.

<12> A conductive material comprising the multi-walled carbon nanotube assembly according to <9> or <10>.

<13> The multi-walled carbon nanotube dispersion liquid according to <11>, which is an ink composition for formation of a lithium battery negative electrode.

<14> An electrode comprising an electrode active material, and the conductive material according to <12>.

<15> A secondary battery comprising the electrode according to <14>.

<16> A composition comprising the multi-walled carbon nanotube assembly according to <9> or <10>, and at least one selected from the group consisting of a resin, a ceramic, and concrete.

<17> A composition comprising: a multi-walled carbon nanotube assembly comprising multi-walled carbon nanotubes and Fe atoms, wherein a content ratio of Fe atoms to a total mass of the assembly is 0.5 mass% or more and less than 10 mass%; and at least one selected from the group consisting of a dispersion medium, a resin, a ceramic, and concrete.

<18> A multi-walled carbon nanotube dispersion liquid comprising multi-walled carbon nanotubes having a tensile strength of 10 MPa to 100 MPa, and a dispersion medium.

<19> A planar assembly comprising the multi-walled carbon nanotube assembly according to <1>, <2>, <9> or <10>.

<20> A filter comprising the planar assembly according to <19>.

<21> An electromagnetic wave shielding comprising the planar assembly according to <19>.

<22> A pellicle for extreme ultraviolet rays comprising the planar assembly according to <19>.

Effects of Invention

According to an embodiment of the present disclosure, there can be provided a multi-walled carbon nanotube assembly having high conductivity and good dispersibility in a dispersion medium, as well as a conductive material, an electrode, a secondary battery, and a planar assembly, each containing the multi-walled carbon nanotube assembly.

According to another embodiment of the present disclosure, there can be provided a multi-walled carbon nanotube dispersion liquid containing a multi-walled carbon nanotube assembly having high conductivity.

According to yet another embodiment of the present disclosure, there can be provided a planar assembly containing multi-walled carbon nanotube powder, and a filter, an electromagnetic wave shielding, and a pellicle for extreme ultraviolet rays, each including the planar assembly.

Brief Description of Drawing

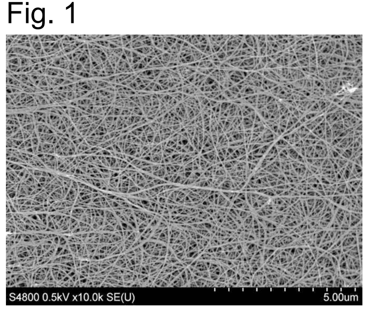

[Figure 1] A scanning electron microscope photograph showing an aspect of the multi-walled carbon nanotube assembly of the present disclosure.

Embodiments for Carrying out Invention

In the present disclosure, a numerical range indicated by "to" means a range that includes numerical values described before and after "to" as the minimum and maximum values, respectively.

In the numerical ranges described in stages in the present disclosure, the upper or lower limit value described in a numerical range may be replaced by the upper or lower limit value of another of the numerical ranges described in stages. In the numerical ranges described in the present disclosure, the upper or lower limit value described in a numerical range may be replaced by a value described in Example.

In the present disclosure, a combination of two or more preferred aspects is a more preferred aspect.

In the present disclosure, the amount of each component means, in the case where there are a plurality of substances corresponding to the substance, the total amount of a plurality of substances unless otherwise specified.

As used herein, the term "step" includes not only independent steps, but also steps which cannot be clearly distinguished from other steps and whose intended purposes are achieved.

<Multi-walled carbon nanotube assembly: first embodiment>

The multi-walled carbon nanotube assembly of the present disclosure is a multi-walled carbon nanotube assembly containing multi-walled carbon nanotubes having a maximum length of 1,000 $\mu$m to 30,000 $\mu$m, and Fe atoms, in which the content ratio of Fe atoms to a total mass of the assembly is 0.5 mass% or more and less than 10 mass%.

The multi-walled carbon nanotube assembly of the present disclosure can take a form such as a sheet shape or a fiber shape.

Here, the sheet-shaped assembly means that the multi-walled carbon nanotube assembly has a sheet shape.

The fiber-shaped assembly means that the multi-walled carbon nanotube has a thread form. The fiber-shaped assembly may contain multi-walled carbon nanotubes in a state of monofilaments (single fibers), or in a state of multi-filaments, i.e., threads in which a plurality of multi-walled carbon nanotube fibers are twisted.

[Multi-walled carbon nanotubes]

The multi-walled carbon nanotube assembly of the present disclosure (which may be hereinafter referred to simply as the "assembly of the present disclosure") includes multi-walled carbon nanotubes having a maximum length of 1,000 $\mu$m to 30,000 $\mu$m. Hereinafter, the "multi-walled carbon nanotube having a maximum length of 1,000 $\mu$m to 30,000 $\mu$m" may be abbreviated as "ULMWCNT".

ULMWCNT has a maximum length of 1,000 $\mu$m to 30,000 $\mu$m, is larger in length than common MWCNT, and can assume a fiber shape.

Here, the term "fiber" is commonly used to indicate a structure in which one dimension is larger than the other two dimensions. The fiber may be a thread-like fiber whose cross-section has a circular shape, a ribbon-like fiber whose cross-section has a rectangular shape, may be hollow, or may have another shape.

From the perspective of enhancing the conductivity of the assembly of the present disclosure, ULMWCNT preferably has a circular cross-section, and is preferably hollow.

ULMWCNT, which assumes a fiber shape, thus has the property of being easily entangled. The assembly of the present disclosure contains at least one ULMWCNT, and is preferably an assembly containing a plurality of ULMWCNT from the perspective that MWCNT is easily entangled to form a more stable assembly. Hereinafter, the assembly containing ULMWCNT may be abbreviated as a "ULMWCNT assembly".

The assembly of the present disclosure may be an assembly of entangled three-dimensional structures.

Figure 1 is a scanning electron microscope (SEM) photograph showing an aspect of the assembly of the present disclosure. From the SEM photograph shown in Figure 1, it can be seen that a plurality of fiber-shaped ULMWCNT is entangled to form a sheet-shaped assembly. As described above, by SEM observation, a state in which ULMWCNT in the assembly of the present disclosure is entangled can be confirmed.

The length of ULMWCNT can be measured by observing a plurality of SEM photographs of adjacent fields of view with a focus on one ULMWCNT. Here, the length is a length in a longitudinal direction of ULMWCNT in the longitudinal direction, and the maximum value among the measured values of length is taken as a "maximum length".

When one ULMWCNT in which the maximum length is in the range of 1,000 $\mu$m to 30,000 $\mu$m exists within the field of view of the SEM photograph through the above-described observation of SEM photographs, it can be confirmed that the observed assembly is the assembly of the present disclosure.

It is preferred that a plurality of ULMWCNT in which the maximum length measured as described above is in the range of 1,000 $\mu$m to 30,000 $\mu$m exist within the field of view of the SEM photograph.

From the perspective of further improving the stability of the assembly from entanglement of ULMWCNT, ULMWCNT in which the maximum length is in the range of 1,000 $\mu$m to 30,000 $\mu$m preferably allows for 10% or more, more preferably allows for 20% or more, further more preferably allows for 30% or more, and particularly preferably allows for 50% or more, on a number basis, of 100 MWCNT within the field of view of the SEM photograph, which is given attention, subjected to measurement of the maximum length respectively and observed by the above-described method.

The diameter of ULMWCNT can be measured by observing SEM photographs or transmission electron microscope photographs (TEM). Here, the diameter is a length of ULMWCNT in a direction orthogonally crossing the longitudinal direction. The diameters of ten different portions of one ULMWCNT are measured, and the average value thereof is taken as a diameter of the ULMWCNT.

The length of ULMWCNT contained in the assembly of the present disclosure is in the range of 1,000 μm to 30,000 μm, preferably in the range of 1,050 μm to 25,000 μm, more preferably in the range of 1,100 μm to 20,000 μm, further more preferably 1,200 μm to 18,000 μm, and particularly preferably in the range of 1,300 μm to 15,000 μm. The diameter of ULMWCNT contained in the assembly of the present disclosure is preferably 1 nm to 100 nm, more preferably 2 nm to 80 nm, further more preferably 3 nm to 50 nm, and particularly preferably 5 nm to 30 nm.

The length/diameter ratio, i.e., the aspect ratio, of ULMWCNT is preferably 1,000 or more, more preferably 3,000 or more, further more preferably 5,000 or more, and particularly preferably 10,000 or more.

The aspect ratio can be calculated from the ratio of the maximum length and the diameter of one ULMWCNT. From the perspective of measurement accuracy, it is preferred to adopt the average of the measured values for 20 or more ULMWCNT.

From the perspective of dispersibility, the specific gravity of the ULMWCNT assembly is preferably in the range of 1.5 to 2.5, more preferably in the range of 1.7 to 2.4, and further more preferably in the range of 1.8 to 2.2.

The specific gravity of the ULMWCNT assembly can be measured by a method described in JIS Z8807-2012, "Methods of measuring density and specific gravity of solid".

The purity of the ULMWCNT assembly as MWCNT can be measured by thermogravimetric analysis. A thermogravimetric (TG) curve and a differential thermal analysis (DTA) curve of the ULMWCNT assembly are obtained using, for example, a thermal analysis apparatus (DTG-60 manufactured by Shimadzu Corporation). In a DTA curve where a peak top appears near 650°C to 750°C, the largest exothermic peak corresponds to combustion of MWCNT, and other exothermic peaks correspond to combustion of substances other than MWCNT. The purity of MWCNT is determined from a ratio of weight loss in the TG curve. From the perspective of the conductivity of the obtained assembly, the purity of the ULMWCNT assembly is preferably 50 mass% or more, more preferably 65 mass% or more, further more preferably 80 mass% or more, and particularly preferably 95 mass% or more.

ULMWCNT may contain 0.01 mass% to 50 mass% of Fe atoms derived from iron which is a catalyst used during production. ULMWCNT may contain Fe atoms with the Fe atoms adsorbed on the surface of ULMWCNT or caught in fiber-shaped ULMWCNT formed during production.

The obtained fiber-shaped ULMWCNT is preferably flexible and robust.

The conductivity of ULMWCNT itself is preferably 5,000 $\Omega^{-1} \cdot m^{-1}$ or more, and more preferably 10,000 $\Omega^{-1} \cdot m^{-1}$ or more. The conductivity of ULMWCNT itself is typically 1,000,000 $\Omega^{-1} \cdot m^{-1}$ or less.

There is no limitation on the method for producing ULMWCNT that is contained in the assembly of the present disclosure.

As a method for producing ULMWCNT in the present disclosure, a heretofore known chemical vapor deposition (CVD) method, a method in which a gaseous reactant containing a carbon source is reacted in the presence of a catalyst, or the like can be applied.

MWCNT in the present disclosure can be produced by referring to, for example, a production method described in Japanese Patent Laid-Open No. 2016-102047.

Hereinafter, an example of a method for producing MWCNT in the present disclosure will be described. However, the method for producing MWCNT in the present disclosure is not limited to the following example.

The method for producing ULMWCNT in the present disclosure is, for example, a method described in Japanese Patent Laid-Open No. 2016-102047, that is, a production method including the steps of allowing one or more gaseous reactants containing a carbon source to pass through a reactor, reacting the one or more gaseous reactants in the presence of a catalyst in a reaction zone of the reactor to form product particles containing carbon, agglomerating the product particles into an agglomerate, and applying a force to the agglomerate to continuously move the agglomerate to outside the reaction zone (hereinafter also referred to as a "production method X").

MWCNT containing ULMWCNT can be obtained in the form of an easily handled fiber-shaped agglomerate, or other forms of agglomerate by the production method X.

In the production method X, the force applied to the product particles may be a mechanical force.

If the agglomerate contains fiber-shaped CNT, the mechanical force applied to the product particles can be provided by a rotating spindle around which the agglomerate containing fiber-shaped CNT is wound. The fiber-shaped CNT may be collected as an assembly on the spindle in the manner mentioned above, or may be wound around the spindle by one or more rotations, with the spindle then successively turned back to accumulate the assembly of fiber-shaped CNT at another position.

In the spindle, a spindle axis is preferably arranged perpendicular or parallel to the flow direction of one or more gaseous reagents, but the spindle axis may be arranged in other orientations. For example, a spindle in which the spindle axis is arranged at an angle of 25° with respect to the direction of a gas flow can also be preferably used for applying a mechanical force to the product particles.

The spindle can rotate around two axes, for example, two perpendicular axes. In particular, the spindle can rotate around axes that are perpendicular and parallel to the direction of the flow of a gaseous reactant, respectively. The spindle can draw or twist an agglomerate containing fiber-shaped CNT so that the twist number and the length can be controlled.

The material of the spindle may be made of metal, ceramic, or resin.

The spindle can assume a suitable shape that varies depending on the properties of the material and the use purpose of the ULMWCNT assembly. The spindle can be used as, for example, a die for producing a carbon product by a spin coating method. The preferred shape of the spindle is rod-shape or box-shape.

Fiber-shaped MWCNT is accumulated on the spindle or at another position, and the coating thickness and the orientation of the MWCNT can be controlled by controlling the reaction time and reaction conditions, or by conditions in which an electric field or another field is applied to the carbon product. The coating thickness and the orientation of the carbon product can be controlled by, for example, the flow force of gas.

The rotation speed of the spindle is preferably 0.01 rpm (rotations/min: the same applies hereinafter) to 10,000 rpm, and more preferably 0.1 rpm to 100 rpm. The spinning speed, that is, the rotation speed of the spindle may be adjusted so that the speed of collection is the same as speed of formation of the material. The thickness of the fiber-shaped ULMWCNT assembly may be controlled by the rotation speed. In a preferred embodiment, the fiber-shaped ULMWCNT assembly is processed in the axial direction of the spindle upon rotation of the spindle. The processing means that fiber-shaped ULMWCNT is equally wound around the spindle rather than being stacked at only one location on the spindle.

For formation of the assembly by accumulation of fiber-shaped ULMWCNT, other units that are used in fiber technology may be used.

The fiber-shaped ULMWCNT assembly may be collected on the wall of the reactor with, for example, a substrate placed in the reactor. The substrate may be a fixed substrate, or may be a rotating guide that is used for applying a strong and equal force to ULMWCNT when the fiber-shaped ULMWCNT is collected. Examples of the appropriate mode of arrangement of the substrate that is used in fiber technology include a substrate comprising two guides located so as to orthogonally cross each other.

In the production method X, the mechanical force applied to the product particles may be a force applied by an accelerated gas flow. The accelerated gas flow can be generated by allowing the product particles to pass through a reactor with a small diameter, or through a capillary located downstream of the reaction zone. A vacuum may be applied to the product particles.

Other forces applied to the product particles may include an electrostatic force that is appropriately applied by a charged plate. When an electrostatic force is used, it is required that the product particles be charged. By using a charged plate, MWCNT can be produced in the form of entangled mats on a charged plate.

Another force applied to the product particles may include a magnetic force, or a photon pressure applied by a light source.

The raw material for CNT may be injected in the form of a liquid containing a carbon source, instead of the gaseous reactant containing a carbon source. When a liquid is used as the raw material for CNT, the liquid can be injected through a single inlet, or multiple inlets by, for example, a showerhead arrangement.

One or more gaseous reactants are preferably reacted at 500°C to 1,600°C, and more preferably reacted at 1,000°C to 1,500°C or 1600°C (particularly, 1,000°C to 1,500°C). Preferably, a temperature gradient is maintained in the reactor, and the reaction zone is kept at a temperature higher than that of the product zone of the reactor.

The gaseous reactant may be used by being mixed with one or more gases that act as a diluent. The gaseous reactants may be mixed with a gas that does not play a direct role in the reaction, but contributes to the reaction. For example, it is also preferred to use a gas as a diluent which, in the case of formation of amorphous carbon as a by-product, reacts with the amorphous carbon to maintain a normal reaction site on a catalyst, thus enabling production of nanotubes.

Examples of the gas that can be used as a diluent include argon or other inert gases, hydrogen, nitrogen, ammonia, carbon dioxide, and helium.

Among them, hydrogen is particularly preferred as a gas that can be used as a diluent. The flow rate of the gas as a diluent is preferably 2,000 mL (milliliters)/min or less, and more preferably 400 mL/min to 800 mL/min.

The gas pressure of the gaseous reactant and any diluent is preferably 0.1 bar to 50 bar, more preferably 0.5 bar to 5 bar, and further more preferably 1 bar to 2 bar. When gas outflow from a furnace occurs, the outflow gas can be recycled with or without cleaning.

By monitoring agglomeration products and changing the reaction conditions according to the resulting information, the composition and the like of the products can be controlled. For example, the product can be monitored by online Raman spectroscopy. For the carbon nanotubes, data indicating whether the nanotubes have a single wall or multiple walls, the diameter of the nanotubes, and the crystallinity of the nanotubes are obtained. The product can also be monitored by online conductivity measurement, gas analysis, and monitoring of the opacity of the reaction zone and/or the winding force. The reaction conditions can be changed by an operator or automatically.

In removal of the agglomerate from the reactor, entrance of air into the reaction is preferably prevented. When the dilution gas contains hydrogen, prevention of entrance of air is particularly important from the perspective of, for example, inhibiting formation of an explosive mixture of hydrogen and air in the reactor.

The product particles in the production method contain ULMWCNT. Depending on production conditions, single-walled carbon nanotubes may be contained in addition to multi-walled carbon nanotubes.

The fiber-shaped ULMWCNT may be formed by chemical vapor deposition. In this case, the carbon source which is a gaseous reactant reacts in the presence of a catalyst.

Examples of the carbon-containing compound that is suitable as a carbon source include carbon monoxide, carbon dioxide, aromatic hydrocarbons (for example, benzene, toluene, xylene, cumene, ethylbenzene, naphthalene or mesitylene), non-aromatic hydrocarbons (for example, methane, ethane, propane, butane, pentane, hexane, cyclohexane, ethylene, propylene or acetylene), and oxygen-containing hydrocarbons (for example, formaldehyde, acetaldehyde, acetone, methanol, ethanol, diethyl ether, polyethylene glycol, 1-propanol, ethyl formate, and hydrocarbons including a mixture of two or more thereof).

The carbon-containing compound is preferably carbon monoxide, methane, ethylene, or acetylene.

The carbon source preferably contains oxygen. Ethanol is a particularly preferred carbon source.

Oxygen can be introduced into the reactor by other methods such as a method using a carbon source containing a dilution gas or water.

The gaseous reactant that is a carbon source is preferably injected into the reactor at a rate of 0.01 mL/min to 10 mL/min, and more preferably at a rate of 0.08 mL/min to 0.25 mL/min.

The catalyst is preferably a transition metal group, in particular, chromium (Cr), molybdenum (Mo) or tungsten (W) that belongs to Group VIB, or a transition metal of Group VIIIB. Specific examples of the preferred catalyst include iron (Fe), cobalt (Co), nickel (Ni), ruthenium (Ru), rhodium (Rh), palladium (Pd), osmium (Os), iridium (Ir), platinum (Pt), manganese (Mn), and mixtures thereof. Metals from lanthanide and actinide series (for example, yttrium (Y)) can also be used as catalysts. Fe, Ni, Co, Mo, and mixtures thereof, for example, mixtures of Ni and Co (mass ratio: 50/50), mixtures of Fe and Ni, or mixtures of Fe and Mo are more preferred.

Any of these transition metals are used alone or in combination with any of other transition metals listed, and can function as a catalyst for growth of CNT. The catalyst is particularly preferably a mixture of two or more metals listed.

It is preferable that the catalyst be formed by decomposition of a precursor. The precursor is preferably a heat-, light- or plasma-decomposable compound of one or more of the above-described metals, such as a carbonyl or cyclopentadienyl organometallic compound. The precursor is particularly preferably ferrocene, iron pentacarbonyl, nickelocene, or cobaltocene. It is appropriate that the carbon source contains at least 0.01 mass% of the precursor, and it is preferred that the carbon source contains 0.2 mass% to 2.5 mass% of the precursor. In certain aspects, the carbon source contains 0.23 mass% to 2.3 mass% of the precursor.

The catalyst may be supported on a carrier, and used. Examples of the preferred carrier include silica and magnesium oxide.

It is preferred that the carbon source be reacted in the presence of an accelerator. An appropriate accelerator is one or more of sulfur, phosphorus, molybdenum, and organic compounds of these elements. Thiophene is one of the preferred accelerators. It is appropriate that the carbon source contains up to 10 mass% (10 mass% or less) of the accelerator. It is preferred that the carbon source contains 0.2 mass% to 6 mass% of the accelerator. When a high or low concentration of thiophene is used as the accelerator, MWCNT is formed.

For example, when ethanol containing 0 mass% or 1.5 mass% to 4.0 mass% of thiophene and 1.0 mass% to 10.0 mass% (particularly, 2.3 mass%) of ferrocene is used, and the conditions are set to an injection rate of 5.0 mL/hour to 30.0 mL/hour (particularly, 7.5 mL/hour), a hydrogen flow rate of 400 mL/min to 800 mL/min, and a synthesis temperature of 1100°C to 1180°C, good MWCNT is formed.

Fiber-shaped CNT having a length of at least 500 $\mu$m, for example, at least 1 mm can be obtained by the production method X. Fiber-shaped CNT can assume a thread-shaped or mat-shaped form.

The length of the fiber-shaped CNT can be controlled by, for example, the winding ability of a spindle used in production of the fiber-shaped CNT.

The production method X preferably includes the steps of reacting a carbon source in the reaction zone of the reactor to form CNT, and applying a force to the CNT to agglomerate the CNT into an agglomerate. By the production method, a fiber-shaped CNT assembly can be easily produced.

In another aspect, a process including forming ULMWCNT in the reaction zone by the above-described method, agglomerating ULMWCNT to form the assembly, and continuously drawing out the assembly from near the reaction zone may be carried out.

In another aspect, a process including forming ULMWCNT in the reaction zone, continuously attracting ULMWCNT electrostatically from the reaction zone, and collecting the ULMWCNT as the assembly can be carried out.

The production method X is illustrative, and the method for producing MWCNT containing ULMWCNT is not limited to that described above.

[Fe atom]

The assembly of the present disclosure contains Fe atoms, and the content ratio of Fe atoms to the total mass of the assembly is 0.5 mass% or more and less than 10 mass%.

ULMWCNT contains carbon, and can be expected to exhibit conductivity, but when ULMWCNT is produced in the presence of a catalyst containing metal atoms such as Fe, the ULMWCNT may contain, for example, Fe atoms derived from a catalyst resulting in reduced conductivity. Heretofore, production of ULMWCNT has been followed by washing with an acid to remove metal atoms such as Fe atoms.

However, studies by the present inventors have shown that when ULMWCNT having a maximum length of 1,000 $\mu$m to 30,000 $\mu$m is contained, the dispersibility in the dispersion medium is further improved while the conductivity of the assembly is maintained by virtue of the fact that the maximum length of CNT is in the above-described range, and the content ratio of Fe atoms to the total mass of the assembly is 0.5 mass% or more and less than 10 mass%.

The content ratio of Fe atoms to the total mass of the assembly of the present disclosure is 0.5 mass% or more and less than 10 mass%, preferably more than 1.0 mass% and less than 10 mass%, more preferably 1.2 mass% to 9.5 mass%, further more preferably 1.5 mass% to 9 mass%, particularly preferably 2 mass% to 8 mass%, and especially preferably 3 mass% to 7 mass%.

The content ratio of Fe atoms to the total mass of the assembly can be measured by, for example, the following method.

The assembly of the present disclosure is completely dissolved in an acid such as hydrochloric acid or nitric acid. For completely dissolving the assembly of the present disclosure in an acid, pretreatment such as dry ashing, wet ashing, or melting treatment may be performed. By performing inductively coupled plasma atomic emission spectroscopy (ICP-AES) or inductively coupled plasma mass spectrometry (ICP-MS) of the solution obtained by completely dissolving the assembly of the present disclosure in an acid, the content ratio of Fe atoms can be measured. ICP-MS is preferably performed because the measurement can be made with higher sensitivity.

As described above, ULMWCNT may contain 0.01 mass% to 50 mass% of Fe atoms derived from iron that is a catalyst used during production. ULMWCNT may contain Fe atoms with the Fe atoms adsorbed on the surface of ULMWCNT or caught in fiber-shaped ULMWCNT formed during production.

That is, in the present disclosure, the Fe atoms contained in the assembly may contain Fe atoms derived from a catalyst used for production of multi-walled carbon nanotubes.

In the assembly of the present disclosure, the content ratio of Fe atoms to the total mass of the assembly is preferably adjusted to an intended content ratio of Fe atoms within the range of 0.5 mass% or more and less than 10 mass% by taking into account the content of the catalyst-derived Fe atoms contained in ULMWCNT. It goes without saying that when the content ratio of catalyst-derived Fe atoms to the total mass of the assembly is an intended content ratio, it is not necessary to carry out a special process for adjusting the content ratio of Fe atoms.

When the content ratio of Fe atoms to the total mass of the assembly is 10 mass% or more, the content ratio of Fe atoms to the total mass of the assembly can be adjusted to less than 10 mass% by a known method, for example, washing the assembly with water, an acid, or an acid aqueous solution (for example, a 1 mass% to 37 mass%, particularly 35 mass% aqueous solution of hydrochloric acid) to remove some of the Fe atoms.

When the content ratio of Fe atoms to the total mass of the assembly is less than 0.5 mass%, the content ratio of Fe atoms to the total mass of the assembly can be adjusted to an amount of 0.5 mass% or more by immersing the assembly in a 1 mass% to 46 mass% (particularly about 5 mass%) aqueous solution of iron nitrate or a 1 mass% to 47 mass% (particularly about 40 mass%) aqueous solution of iron chloride as a source of Fe atoms to adsorb Fe atoms to the surface of fiber-shaped ULMWCNT.

The mechanism related to the improvement of conductivity and dispersibility in the assembly of the present disclosure is not known, but can be assumed as follows. However, the following assumption does not limit the interpretation of the assembly of the present disclosure, and are presented as an example.

If known short CNT contains Fe atoms, there is a problem that the presence of Fe atoms narrows the contacts between the nanotubes, so that conductive paths are hardly connected, resulting in reduced conductivity.

In ULMWCNT contained in the assembly of the present disclosure, the maximum length is in the range of 1,000 $\mu$m to 30,000 $\mu$m, so that the contacts between the nanotubes widen, and agglomeration is likely to occur. Here, it is considered that in a state where a moderate amount of Fe atoms adheres to the surface of ULMWCNT, the assembly contains the Fe atoms, and thus the contact between a plurality of ULMWCNT is moderately inhibited by the Fe atoms, so that agglomeration is suppressed, resulting in improvement of dispersibility. It is considered that suppression of agglomeration of ULMWCNT generally reduces conductivity, but in ULMWCNT contained in the assembly of the present disclosure, in which the maximum length is in the range of 1,000 $\mu$m to 30,000 $\mu$m, a sufficient contact area is secured even if the agglomeration is suppressed by the presence of Fe atoms, so that both improved dispersibility and good conductivity are achieved.

Even in ULMWCNT, if the ULMWCNT has an Fe atom content of 10 mass% or more, the presence of Fe atoms narrows the contacts between the nanotubes, so that conductive paths are hardly connected, resulting in reduced conductivity. In ULMWCNT having an Fe atom content of less than 0.5 mass%, the effect of suppressing agglomeration by the presence of Fe atoms is not exhibited, and the contacts between the nanotubes widen. Thus, good conductivity is obtained, but dispersibility is reduced.

Since the content of Fe atoms to the total mass of the assembly of the present disclosure is in the above-described range, the specific gravity of the ULMWCNT assembly is slightly increased by the presence of Fe atoms.

For example, when the content ratio of Fe atoms in the assembly is 5 mass%, the specific gravity is about 2.2.

An additional effect is that since graphite and Ketjenblack which are carbon materials in the electrode have specific gravities of 2.2 and 2.7, respectively, the use of the assembly of the present disclosure as a conductive auxiliary agent which will be described later decreases the difference in specific gravity between the assembly and the carbon material due to the increase of the specific gravity of the assembly by Fe atoms, so that dispersibility in the carbon material is further improved.

The method for measuring the specific gravity of the assembly is as described for the multi-walled carbon nanotubes.

<Multi-walled carbon nanotube assembly: second embodiment>

Examples of the second embodiment of the multi-walled carbon nanotube assembly include a multi-walled carbon nanotube assembly containing multi-walled carbon nanotubes having a tensile strength of 10 MPa to 100 MPa, and Fe atoms, in which the content ratio of Fe atoms to the total mass of the assembly is 0.5 mass% or more and less than 10 mass%.

The second embodiment of the multi-walled carbon nanotube assembly is a multi-walled carbon nanotube assembly containing multi-walled carbon nanotubes having a tensile strength of 10 MPa to 100 MPa, and Fe atoms, in which the content ratio of Fe atoms to the total mass of the assembly is 0.5 mass% or more and less than 10 mass%.

In the present disclosure, the "tensile strength" refers to the value measured by referring to the tensile test described in ISO 527-1.

The tensile strength of the multi-walled carbon nanotubes according to the second embodiment of the present disclosure is given as a value measured in a state that enables extension, such as that of a sheet shape or a fiber shape.

When the multi-walled carbon nanotube assembly has a sheet-shape, the sheet-shaped assembly is cut into 75 mm × 10 mm to obtain a measurement sample, which is fixed to a gripping part of a tensile tester (manufactured by Shimadzu Corporation, Autograph AGS-X series), a tensile test is conducted at a tension rate of 1 mm/min, and the rupture strength at breakage of the measurement sample is taken as a tensile strength.

When the multi-walled carbon nanotubes have a thread-shape, the fiber-shaped multi-walled nanotubes are cut into a length of 500 mm to obtain a measurement sample, which is fixed to a gripping part of a tensile tester (manufactured by Shimadzu Corporation, Autograph AGS-X series), a tensile test is conducted at a tension rate of 1 mm/min using a thin wire gripping tool (manufactured by Shimadzu Corporation), and the rupture strength at breakage of the measurement sample is taken as a tensile strength.

If the sheet-shaped measurement sample does not reach the above-described size, or the thread-shaped measurement sample does not reach the above-described length, the tensile strength is measured by directly using the measurement sample.

It is preferable that the tensile strength of the multi-walled carbon nanotubes according to the present disclosure is 10 MPa or more and 100 MPa or less, more preferably 30 MPa or more and 85 MPa or less, and further more preferably 50 MPa or more and 70 MPa or less. When the tensile strength of the multi-walled carbon nanotubes is 50 MPa or more, the maximum length of the multi-walled carbon nanotubes is sufficient, and therefore, the conductivity of the multi-walled carbon nanotubes is easily secured. When the tensile strength of the multi-walled carbon nanotubes is 70 MPa or less, little force is required for pulverization of the sheet-shaped or fiber-shaped multi-walled carbon nanotubes as needed, and therefore, pulverization which is as-needed post-processing can be easily performed.

As the pulverization method for pulverizing the multi-walled carbon nanotubes having a tensile strength of 10 MPa to 100 MPa according to the present disclosure, as needed, for example, a freeze-pulverization method can be used. The freeze-pulverization method is a processing method in which regardless of whether multi-walled carbon nanotube assembly has a sheet shape or a fiber shape, the multi-walled carbon nanotube assembly is rapidly cooled with liquid nitrogen to eliminate the elasticity of the multi-walled carbon nanotubes, so that pulverization is facilitated. Alternatively, pulverization may be performed by a known pulverization method using a ball mill or the like.

The multi-walled carbon nanotube assembly contains Fe atoms, and the content ratio of Fe atoms to the total mass of the assembly is 0.5 mass% or more and less than 10 mass%. In the second embodiment of the assembly of the present disclosure, the content ratio of Fe atoms to the total mass is 0.5 mass% or more and less than 10 mass%, preferably more than 1.0 mass% and less than 10 mass%, more preferably 1.2 mass% to 9.5 mass%, further more preferably 1.5 mass% to 9 mass%, particularly preferably 2 mass% to 8 mass%, and especially preferably 3 mass% to 7 mass%.

Unless otherwise specified, the term "assembly of the present disclosure" refers to the assembly of the first embodiment of the present disclosure.

<Method for producing assembly of the present disclosure>

The assembly of the present disclosure is obtained by adjusting an assembly containing ULMWCNT, which is obtained by the above-described production method, so that the content ratio of Fe atoms to the total mass of the assembly is in the range of 0.5 mass% or more and less than 10 mass%. The method for adjusting the content ratio of Fe atoms is as described above.

The content ratio of Fe atoms can be adjusted by first measuring the content ratio of Fe atoms derived from a reaction catalyst in the assembly containing ULMWCNT, and then removing or further adsorbing Fe atoms depending on the content ratio. When the content ratio of Fe atoms in the assembly containing ULMWCNT is within a target value range, it is not necessary to specially adjust the content ratio of Fe atoms.

<Physical properties of assembly of the present disclosure>

1. Rsp value

The Rsp value of the assembly of the present disclosure with respect to a dispersion medium is preferably 300 to 10,000, more preferably 500 to 7,000, and further more preferably 1,000 to 5,000, and particularly preferably 3,500 to 4,500.

The Rsp value is an indication of affinity for the dispersion medium, and can be measured by a pulse nuclear magnetic resonance (pulse NMR) method. The pulse NMR method is suitable for measurement of affinity for a dispersion medium for a dispersion like the assembly of the present disclosure because the measurement can be made without dilution of a dispersion liquid, and the shape of the dispersoid is not approximated by a spherical shape. If the Rsp value of the dispersion medium of the assembly of the present disclosure with respect to the dispersion medium is within an appropriate range, it can be determined that the assembly of the present disclosure has good dispersibility in the dispersion medium.

Using a pulse NMR apparatus, a relaxation time $T_{2s}$ is measured with the dispersion liquid placed in a sample tube and a relaxation time $T_{2b}$ is measured with only the dispersion medium placed in the test tube. By comparing the relaxation times, the Rsp value can be calculated from the following expression.

$$Rsp = (T_{2b} / T_{2s}) - 1$$

2. Viscosity

In the assembly of the present disclosure, the viscosity of the dispersion liquid tends to decrease because of high affinity for the dispersion medium as described above. When the viscosity of the dispersion liquid is in an appropriate range, it can be determined that the assembly of the present disclosure has good dispersibility in the dispersion medium.

The viscosity of the dispersion liquid at a shear rate of $1 \text{ s}^{-1}$ is preferably 0.1 Pa·s to 4.8 Pa·s, more preferably 0.5 Pa·s to 4.5 Pa·s, and further more preferably 1.0 Pa·s to 4.2 Pa·s. The viscosity of the dispersion liquid at a shear rate of $100 \text{ s}^{-1}$ is preferably 0.001 Pa·s to 0.11 Pa·s, more preferably 0.005 Pa·s to 0.1 Pa·s, and further more preferably 0.01 Pa·s to 0.09 Pa·s.

The viscosity at each shear rate can be obtained by rheometer measurement. For example, using a viscoelasticity measurement apparatus (manufactured by Anton Paar, MCR 302), the shear rate dependency of viscosity can be evaluated under the following measurement conditions.

Measurement fixture: Cone plate
Measurement mode: Rotation mode
Shear rate: $0.01 \text{ s}^{-1}$ to $1,000 \text{ s}^{-1}$
Temperature: 25°C
From the obtained data, the viscosity at the following shear rates is read.

$$\text{Shear rate} = 1 \text{ s}^{-1}$$

$$\text{Shear rate} = 100 \text{ s}^{-1}$$

3. Conductivity

The assembly of the present disclosure, which contains carbon as a main component, thus has good conductivity.

The conductivity of the assembly of the present disclosure can be determined from the volume resistivity. When the volume resistivity measured under the following conditions is below a predetermined value, it can be determined that the polymer of the present disclosure has good conductivity.

The conductivity of the assembly of the present disclosure which is calculated from the volume resistivity is preferably $1.5 \times 10^{-2}\ \Omega\cdot\text{cm}$ or less, more preferably $1.0 \times 10^{-5}\ \Omega\cdot\text{cm}$ to $1.2 \times 10^{-2}\ \Omega\cdot\text{cm}$, further more preferably $5.0 \times 10^{-5}\ \Omega\cdot\text{cm}$ to $1.0 \times 10^{-2}\ \Omega\cdot\text{cm}$, and particularly preferably $1.0 \times 10^{-4}\ \Omega\cdot\text{cm}$ to $9.9 \times 10^{-3}\ \Omega\cdot\text{cm}$ under a press condition of 5 kN.

The volume resistivity of the assembly of the present disclosure is measured by a four-probe method at 25°C using a resistivity meter. As a resistivity meter, a Loresta apparatus can be used.

Specifically, using a Loresta apparatus (product name: Powder Resistivity Measurement System MCP-PD51, Low Resistivity Meter Loresta-GP, Powder Low Resistivity Probe MCP-PD511 (a constant current application-type four-probe method), all manufactured by Nittoseiko Analytech Co., Ltd.), the multi-walled carbon nanotube assembly is introduced into a powder resistivity measurement probe unit, and pressed at 5 kN with an accompanying hydraulic pump. After attainment of a target load, the volume resistivity ($\Omega\cdot\text{cm}$) was measured.

When it is necessary to pulverize the assembly in measurement of the volume resistivity of the assembly of the present disclosure, for example, as described above, a freeze-pulverization method can be used. Alternatively, pulverization using a known pulverization method such as ball milling may be performed.

The volume resistivity of the assembly of the present disclosure can also be calculated from a surface resistance value measured by the following method.

The surface resistance value of the ULMWCNT assembly is measured with Loresta EP MCP-T360 (manufactured by Dian Instrument Co., Ltd.) by conducting a four-probe method resistivity test according to JIS K 7149-1994. The volume resistivity is calculated by multiplying the thickness of the assembly by the surface resistivity value obtained by the four-probe method. From the obtained volume resistivity, the conductivity of the assembly is calculated.

The thickness of the assembly of the present disclosure can be measured with a thickness measuring device having two circular horizontal plates according to the thickness measurement method in JIS L 1913-2010, "Test methods for nonwovens", ISO Method A.

[Conductive auxiliary agent]

As described above, the assembly of the present disclosure has good conductivity. Therefore, the assembly of the present disclosure can be used as a conductive auxiliary agent (preferably, conductive auxiliary agent for negative electrodes).

The conductive auxiliary agent has a function of further improving the conductivity of the conductive material by coexisting with conductive materials such as a positive electrode active material and a negative electrode active material.

Since the assembly of the present disclosure contains ULMWCNT, the assembly of the present disclosure can be used as a conductive auxiliary agent in addition to known conductive auxiliary agents such as graphite and Ketjenblack for the active material as a conductive material.

As described above, the assembly of the present disclosure contains Fe atoms at a predetermined content ratio. For this reason, the assembly of the present disclosure tends to have a slightly larger specific gravity over assemblies of ULMWCNT whose specific gravity is generally in the range of 1.8 to 2.0.

For example, when the content ratio of Fe atoms in the assembly is set to 5 mass%, the specific gravity of the assembly is about 2.2, and the difference in specific gravity between the assembly and graphite (specific gravity 2.2) or Ketjenblack (specific gravity 2.7) which is a carbonaceous material as a conductive auxiliary agent decreases, so that dispersibility in a dispersion medium originally contained in the assembly of the present disclosure, as well as dispersibility in a carbonaceous material used in combination, is further improved.

As an example of use as a conductive auxiliary agent, for example, when a positive electrode of a battery is produced, a positive electrode active material, a conductive auxiliary agent which is the assembly of the present disclosure, and a binder are mixed at a predetermined mass ratio, a solvent is added to the mixture to prepare a slurry, which is applied onto a current collector for positive electrodes, and dried, and stretching is performed to prepare a positive electrode.

As another example of use as a conductive auxiliary agent, for example, when a negative electrode of a battery is produced, a negative electrode active material, a conductive auxiliary agent which is the assembly of the present disclosure, and a binder are mixed at a predetermined mass ratio, a solvent is added to the mixture to prepare a slurry, which is applied onto a current collector for negative electrodes, and dried, and stretching is performed to prepare a negative electrode.

A combination of a carbon material as a conductive material and a conductive auxiliary agent which is the assembly of the present disclosure has been described above, the use as a conductive auxiliary agent in the present disclosure is not limited thereto.

When the assembly of the present disclosure is used as a conductive auxiliary agent, it can be used at any ratio to the total mass of the solid content of the material containing a conductive material and the conductive auxiliary agent.

The assembly of the present disclosure itself may be used as a conductive material. The conductive material of the present disclosure includes the assembly of the present disclosure described above.

The conductive material is used as an electrode material in a battery such as a lithium ion battery, specifically a negative electrode active material, a positive electrode active material, or the like.

<Multi-walled carbon nanotube dispersion liquid>

The assembly of the present disclosure can be preferably used as a dispersion liquid because of good dispersibility.

The multi-walled carbon nanotube dispersion liquid of the present disclosure contains the above-described assembly of the present disclosure, and a dispersion medium.

Another multi-walled carbon nanotube dispersion liquid of the present disclosure contains multi-walled carbon nanotubes having a tensile strength of 10 MPa to 100 MPa, and a dispersion medium.

The multi-walled carbon nanotube dispersion liquid may be referred to simply as the dispersion liquid of the present disclosure.

[Dispersion medium]

Dispersion medium that can be contained in the dispersion liquid of the present disclosure will be described.

The dispersion medium preferably contains water, and more preferably contains water as a main component.

The phrase "containing water as a main component" means that the proportion of water in the dispersion medium is more than 50 mass%. The proportion of water in the dispersion medium is preferably 90 mass% or more, more preferably 95 mass% or more, and further more preferably 99 mass% or more, and may be, for example, 100 mass%.

The water is not limited, but is preferably distilled water, ion-exchange water, pure water, or the like because it contains few impurities.

The dispersion medium may be a mixture of water and a hydrophilic solvent.

Examples of the hydrophilic solvent include carbonate compounds such as ethylene carbonate, propylene carbonate, dimethyl carbonate, diethyl carbonate, methyl ethyl carbonate and butylene carbonate; ether compounds such as tetrahydrofuran; ketone compounds such as acetone; lower alcohol compounds such as methanol and ethanol; and solvents such as acetonitrile.

When the dispersion medium contains a hydrophilic solvent, the proportion of the hydrophilic solvent in the dispersion medium is 10 mass% or less, more preferably 5 mass% or less, and further more preferably 1 mass% or less.

The dispersion liquid of the present disclosure may further contain, in addition to the assembly of the present disclosure and a dispersion medium, other components that can be used for the dispersion liquid.

Examples of the other components include dispersants, defoamers, antistatic agents, CNT other than ULMWCNT according to the present disclosure, and carbon materials other than CNT. The dispersion liquid may further contain a small amount of impurity components, so-called unavoidable impurities, and the like.

[Dispersant]

The dispersion liquid of the present disclosure may contain a dispersant for the purpose of further improving the dispersibility and the dispersion stability of the assembly of the present disclosure.

The dispersant is not limited, and examples thereof include various surfactants. In addition, examples of the dispersant include polymer compounds such as resins.

The dispersant is preferably a surfactant.

The surfactant is not limited, and may be an ionic surfactant or a non-ionic surfactant.

The surfactants can be used alone or in a mixture of two or more thereof.

Examples of the ionic surfactant include anionic surfactants, cationic surfactants, and amphoteric surfactants.

Examples of the anionic surfactant include aromatic sulfonic acid-based surfactants such as alkylbenzene sulfonic acid salts (for example, dodecylbenzenesulfonic acid), and dodecylphenyl ether sulfonic acid salts; ether sulfate-based surfactants; phosphate-based surfactants; and carboxylic acid-based surfactants.

Examples of the cationic surfactant include alkyl amine salts, and quaternary ammonium salts.

Examples of the amphoteric surfactant include alkyl betaine-based surfactants, and amine oxide-based surfactants.

The ionic surfactant is preferably an ionic surfactant having an aromatic ring (so-called an aromatic ionic surfactant), and more preferably an aromatic sulfonic acid-based surfactant such as an alkylbenzene sulfonic acid salt or a dodecylphenyl ether sulfonic acid salt.

The aromatic ionic surfactant tends to be excellent in dispersion ability, dispersion stabilization ability and increased concentration for the multi-walled carbon nanotube assembly.

Examples of the non-ionic surfactant include sugar ester surfactants such as sorbitan fatty acid esters and polyoxyethylene sorbitan fatty acid esters; fatty acid ester-based surfactants such as polyoxyethylene resin acid esters and polyoxyethylene fatty acid diethyl; ether-based surfactants such as polyoxyethylene alkyl ether, polyoxyethylene alkyl phenyl ether and polyoxyethylene/polypropylene glycol; and aromatic non-ionic surfactants such as polyoxyalkylene octyl phenyl ether, polyoxyalkylene nonyl phenyl ether, polyoxyalkyl dibutyl phenyl ethers, polyoxyalkyl styryl phenyl ether, polyoxyalkyl benzyl phenyl ether, polyoxyalkyl bisphenyl ether, polyoxyalkyl cumyl phenyl ether, and polyoxyalkylene phenyl ether.

The non-ionic surfactant is preferably an ionic surfactant having an aromatic ring (so-called an aromatic non-ionic surfactant), more preferably polyoxyalkylene phenyl ether, and further more preferably polyoxyethylene phenyl ether.

The aromatic non-ionic surfactant tends to be excellent in dispersion ability, dispersion stabilization ability and increased concentration for the multi-walled carbon nanotube assembly.

Examples of other dispersants that are excel in dispersion ability, dispersion stabilization ability and increased concentration for the multi-walled carbon nanotube assembly include β-naphthalenesulfonic acid formalin condensates Demol (registered trademark: the same applies to the following) N, Demol RN and Demol T (manufactured by Kao Corporation), polyoxyethylene stearyl ether Brij S 100 (manufactured by Sigma-Aldrich Co. LLC), polyvinylpyrrolidone K30 (manufactured by, for example, FUJIFILM Wako Pure Chemical Corporation), carboxymethyl cellulose (CMC) (manufactured by, for example, Daicel Miraizu Ltd.), sodium deoxycholate (manufactured by, for example, FUJIFILM Wako Pure Chemical Corporation), and SOLSPERSE(TM) W100 and SOLSPERSE(TM) W150 (manufactured by Lubrizol Japan Limited). CMC is particularly preferred from the perspective of being excellent in dispersion ability, dispersion stabilization ability and increased concentration for the multi-walled carbon nanotube assembly.

When the dispersion liquid of the present disclosure contains a dispersant, the amount of the dispersant used is not limited, and can be appropriately set according to the type of dispersant, the amount of the multi-walled carbon nanotube assembly, the amount of the dispersion medium, and the like.

[Method for producing dispersion liquid]

The method for producing the dispersion liquid of the present disclosure is not limited.

The dispersion liquid of the present disclosure can be produced by dispersing the assembly of the present disclosure in a dispersion medium. That is, the dispersion liquid according to the present disclosure can be produced by a method including the step of dispersing the multi-walled carbon nanotube assembly according to the present disclosure in a dispersion medium (also referred to as a "dispersion step").

The dispersion medium that can be used in the dispersion step is as described above.

The dispersion method is not limited.

Examples of the dispersion method include methods using a dispersion apparatus such as a stirrer, a homogenizer, a colloid mill, a flow jet mixer, a dissolver, a paint conditioner, a Manton emulsifying apparatus, a jet mill, or an ultrasonic apparatus.

In addition, examples of the dispersion method include known pulverizing processes such as ball milling (for example, a ball mill, a vibration ball mill, a planetary ball mill, or a bead mill), sand milling, colloid milling, jet milling, roller milling, methods using a disperser such as a vertical or lateral agitator mill, an attritor, a colloid mill, a three-roll mill, a pearl mill, a super mill, an impeller, a disperser, a KD mill, a dynatron, or a pressurized kneader.

As the dispersion method, a method using a jet mill is preferred, and a method using a wet jet mill is more preferred.

The wet jet mill is a dispersion apparatus that turns a mixture in a solvent into a high-speed flow, which is sent under pressure from a nozzle arranged in a sealed state in a pressure-resistant vessel. In the wet jet mill, the multi-walled carbon nanotube assembly is dispersed by means of collisions between opposing flows, collisions with the vessel wall, turbulence generated by the high-speed flow, a shear flow, and the like in the pressure-resistant vessel. As the wet jet mill, ultra-high-pressure homogenizers (model number: NAGS20, NAGS100, NAGS200, NAGS1000 and the like) manufactured by JOKOH can be preferably used. However, the wet jet mill is not limited thereto.

When the above-described ultra-high-pressure homogenizer as a dispersion apparatus, the dispersion process pressure is preferably 10 MPa to 250 MPa.

The method for producing the dispersion liquid of the present disclosure may include, before the dispersion step, the step of drying the assembly of the present disclosure (also referred to as a "drying step").

When moisture adheres to the multi-walled carbon nanotubes, the surface tension of water makes it easier for the multi-walled carbon nanotubes to adhere to each other, raising concerns about deterioration of dispersibility. Therefore, by performing the step of drying the assembly before the dispersion step, moisture adhering to the surface of ULMWCNT contained in the assembly is removed to suppress adhesion between ULMWCNT due to adhesion of moisture, so that the dispersibility of the assembly of the present disclosure in the dispersion medium can be further improved.

The drying method is not limited.

Examples of drying method include heating drying, vacuum drying, and heating vacuum drying.

The drying method is preferably heating vacuum drying.

The drying temperature is not limited, and is preferably 40°C to 100°C.

The drying time is not limited, and can be appropriately set according to, for example, the drying temperature, and the degree to which moisture adheres to the assembly of the present disclosure.

[Application of dispersion liquid]

The dispersion liquid of the present disclosure can be used for various purposes because the assembly of the present disclosure has good dispersibility in the dispersion medium, and excellent conductivity is exhibited.

Examples of the application of the dispersion liquid include conductive ink, antistatic agents, conductive materials for forming a circuit pattern, materials for transparent electrodes, and fillers for water-soluble polymers, and use as conductive ink is preferred.

The dispersion liquid of the present disclosure is preferably applied, among conductive inks, to an ink composition for formation of a lithium battery negative electrode.

By using the dispersion liquid of the present disclosure as an ink composition for formation of a lithium battery negative electrode, negative electrodes of lithium batteries which have good conductivity can be easily produced.

When the dispersion liquid of the present disclosure is applied to conductive ink, the conductive ink can be produced by a method similar to that for the dispersion liquid of the present disclosure except that components of conductive ink such as a viscosity modifier and an antioxidant are further incorporated.

Examples of the application aspect of the assembly of the present disclosure include electrodes and secondary batteries which contain the assembly of the present disclosure as a conductive auxiliary agent.

An electrode containing the conductive auxiliary agent according to the present disclosure is excellent in formation of conductive paths in the electrode. Therefore, a secondary battery including the electrode has excellent cycle characteristics.

The electrode may contain the conductive auxiliary agent according to the present disclosure. The conductive auxiliary agent contained in the electrode is identical to the conductive auxiliary agent according to the present disclosure, and hereinafter, the description of the conductive auxiliary agent is omitted.

The electrode may be at least one of a positive electrode and a negative electrode.

The electrode may include an electrode active material layer. The electrode may include a current collector, and an electrode active material layer arranged on the current collector.

The current collector is not limited as long as it does not induce a chemical change in the battery, and is conductive. For example, as a current collector, copper, stainless steel, aluminum, nickel, titanium, baked carbon, aluminum or stainless steel, whose surface has been treated with carbon, nickel, titanium, silver or the like, may be used. Specifically, a transition metal which adsorb carbon well, such as copper or nickel may be used as the current collector.

The electrode active material layer may contain an electrode active material.

The electrode active material is preferably electrode active material particles.

When the electrode is a positive electrode, the electrode active material particles are not limited, and may include a positive electrode active material that are commonly used for electrode materials for positive electrodes. Specific examples of the positive electrode active material include layered compounds such as lithium cobalt oxide ($LiCoO_2$) and lithium nickel oxide ($LiNiO_2$), compounds substituted with one or more transition metals; lithium iron oxides such as $LiFe_3O_4$; lithium manganese oxides of formulae, for example, $Li_{1+c1}Mn_{2-c1}O_4$ ($0 \leq c1 \leq 0.33$), $LiMnO_3$, $LiMn_2O_3$ and $LiMnO_2$; lithium copper oxide ($Li_2CuO_2$); vanadium oxides such as $LiV_3O_8$, $V_2O_5$ and $Cu_2V_2O_7$; Ni site-type lithium nickel oxides represented by the formula $LiNi_{1-c2}M_{c2}O_2$ (where M is at least one selected from the group consisting of Co, Mn, Al, Cu, Fe, Mg, B and Ga, and $0.01 \leq c2 \leq 0.66$ is satisfied); lithium manganese composite oxides represented by the formula $LiMn_{2-c3}M_{c3}O_2$ (where M is at least one selected from the group consisting of Co, Ni, Fe, Cr, Zn and Ta, and $0.01 \leq c3 \leq 0.1$ is satisfied) or $Li_2Mn_3MO_8$ (where M is at least one selected from the group consisting of Fe, Co, Ni, Cu and Zn); and $LiMn_2O_4$

where a part of Li in the formula is replaced with an alkaline earth metal ion.

When the electrode is a negative electrode, the electrode active material is not limited, and may include a negative electrode active material that is commonly used for electrode materials for negative electrodes.

Specifically, the negative electrode active material may include graphite-based active material particles or silicon-based active material particles. For the graphite-based active material particles, one or more selected from the group consisting of artificial graphite, natural graphite, graphitized carbon fibers, and graphitized mesocarbon microbeads may be used. By using artificial graphite, the rate characteristics can be improved.

For the silicon-based active material particles, one or more selected from the group consisting of Si, $SiO_x$ ($0 < x < 2$), Si-C complexes, and Si-Y alloys (where Y is an element selected from the group consisting of an alkali metal, an alkaline earth metal, a transition metal, a Group 13 element, a Group 14 element, a rare earth element and a combination thereof) may be used. By using silicon-based active material particles, the capacity of the battery can be increased.

The electrode active material layer may further contain a binder.

The binder is not limited, and may include a binder that is commonly used for electrode materials. The binder is, for example, at least one polymer selected from the group consisting of a polyvinylidene fluoride-hexafluoropropylene copolymer (PVDF-co-HFP), polyvinylidene fluoride, polyacrylonitrile, polymethyl methacrylate, polyvinyl alcohol, carboxymethyl cellulose (CMC), starch, hydroxypropyl cellulose, regenerated cellulose, polyvinyl pyrrolidone, tetrafluoroethylene, polyethylene, polypropylene, ethylene-propylene-diene monomers (EPDM), sulfonated EPDM, styrene-butadiene rubber (SBR), fluororubber and polyacrylic acid, and as well as any of these polymers subjected to replacement of hydrogen atoms thereof with Li, Na, Ca or the like.

<Secondary battery>

The secondary battery may include a negative electrode, a positive electrode, a separator interposed between the positive electrode and the negative electrode, and an electrolyte. At least one of the positive electrode and the negative electrode is an electrode according to the present disclosure, with the negative electrode being preferably an electrode according to the present disclosure.

The separator provides a passage for movement of lithium ions by separating a negative electrode and a positive electrode, and is not limited as long as the separator is commonly used as a separator in a secondary battery. The separator preferably has low resistance to movement of ions of the electrolyte and excellent electrolytic solution retention capability.

Specific examples of the separator include porous polymer films. The porous polymer film may be, for example, a porous polymer film made from a polyolefin-based polymer such as an ethylene homopolymer, a propylene homopolymer, an ethylene/butene copolymer, an ethylene/hexene copolymer, or an ethylene/methacrylate copolymer, or a laminated structure obtained by laminating any two or more of the films.

The separator may be a common porous non-woven fabric, a non-woven fabric made from high-melting-point glass fibers, polyethylene terephthalate fibers, or the like. The separator may be coated so as to include a ceramic component or polymeric material for securing heat resistance or mechanical strength. For the separator, a single-layered or multi-layered structure can be selected.

Examples of the electrolyte include, but are not limited to, organic liquid electrolytes, inorganic liquid electrolytes, solid polymer electrolytes, gelled polymer electrolytes, solid inorganic electrolytes, and molten inorganic electrolytes, which can be used in production of lithium-ion secondary batteries.

Specifically, the electrolyte may contain a nonaqueous organic solvent and a metal salt.

Examples of the nonaqueous organic solvent include aprotic organic solvents such as N-methyl-2-pyrrolidinone, propylene carbonate, ethylene carbonate, butylene carbonate, dimethyl carbonate, diethyl carbonate, $\gamma$-butyrolactone, 1,2-dimethoxyethane, tetrahydroxyfuran, 2-methyltetrahydrofuran, dimethyl sulfoxide, 1,3-dioxolane, formamide, dimethylformamide, dioxolane, acetonitrile, nitromethane, methyl formate, methyl acetate, triester phosphate, trimethoxymethane, dioxolane derivatives, sulfolane, methylsulfolane, 1,3-dimethyl-2-imidazolidinone, propylene carbonate derivatives, tetrahydrofuran derivatives, ether, methyl propionate, and ethyl propionate.

Among the carbonate-based organic solvents, ethylene carbonate and propylene carbonate, which are cyclic carbonate, can be preferably used as the nonaqueous organic solvent because they have a high dielectric constant as high-viscosity organic solvents, and sufficiently dissociate a lithium salt. When such cyclic carbonate used as a nonaqueous organic solvent is mixed at an appropriate ratio with linear carbonate having a low viscosity and a low dielectric constant, such as dimethyl carbonate or diethyl carbonate, an electrolyte having a high conductivity can be obtained, which is more preferred.

The metal salt may be a lithium salt.

The lithium salt is a substance that is easily dissolved in a nonaqueous electrolytic solution.

The anion moiety of the lithium salt is, for example, one or more selected from the group consisting of $F^-$, $Cl^-$, $I^-$, $NO_3^-$, $N(CN)_2^-$, $BF_4^-$, $ClO_4^-$, $PF_6^-$, $(CF_3)_2PF_4^-$, $(CF_3)_3PF_3^-$, $(CF_3)_4PF_2^-$, $(CF_3)_5PF^-$, $(CF_3)_6P^-$, $CF_3SO_3^-$, $CF_3CF_2SO_3^-$,

$(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$, and $(CF_3CF_2SO_2)_2N^-$.

For the purpose of enhancing life characteristics of the battery, inhibiting decrease of the battery capacity, and enhancing discharge capacity of the battery, the electrolyte may contain, in addition to the nonaqueous organic solvent and the metal salt as constituents of the electrolyte, one or more additives such as a haloalkylene carbonate compound such as difluoroethylene carbonate, pyridine, triethyl phosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxyethanol, or aluminum trichloride.

The secondary battery can form a battery module including the secondary batteries as unit cells, and a battery pack including the battery module. The battery module and the battery pack can be used as a power supply for a middle- or large-sized device selected from the group consisting of an electric vehicle, a hybrid electric vehicle, a plug-in hybrid electric vehicle, and a power storage system.

<Composition>

[Resin, ceramic, and concrete, etc.]

The composition according to the present disclosure is a composition containing the assembly of the present disclosure, and at least one selected from the group consisting of a resin, a ceramic and concrete.

Another composition according to the present disclosure is a composition containing: a multi-walled carbon nanotube assembly containing multi-walled carbon nanotubes and Fe atoms, in which the content ratio of Fe atoms to the total mass of the assembly is 0.5 mass% or more and less than 10 mass%; and at least one selected from the group consisting of a dispersion medium, a resin, a ceramic, and concrete.

Examples of the resin include thermoplastic resins and thermosetting resins, and preferred are olefin-based resins, polycarbonate-based resins, polyester-based resins, polyamide-based resins, thermoplastic polyurethane resins, polysulfone-based resins, and silicone resins.

Examples of ceramic include crystalline ceramics, and amorphous ceramics.

Examples of the concrete include Portland cement concrete.

The composition according to the present disclosure may further contain other components such as water and an organic solvent.

When the content of the assembly of the present disclosure in the composition according to the present disclosure is 100 parts by mass, the content of at least one selected from the group consisting of a resin, a ceramic, and concrete is typically 10 to 1,000,000 parts by mass, preferably 100 to 100,000 parts by mass, and more preferably 1,000 to 40,000 parts by mass, and is preferably 1 to 10,000 parts by mass, and more preferably 10 to 1,000 parts by mass when other components are contained.

The composition according to the present disclosure may contain one or more types of each of the assembly of the present disclosure, the resin, the ceramic, the concrete and the other component.

[Method for producing composition]

The composition according to the present disclosure can be produced by kneading the assembly of the present disclosure with a resin, a ceramic, or uncured concrete. The resin may be in the form of powder, pellets, a solution, or a dispersion liquid. The ceramic may be in the form of powder, a precursor solution, or a dispersion liquid.

The composition according to the present disclosure can also be produced by dispersing the assembly of the present disclosure in a solution of resin, a ceramic precursor or dispersion liquid, or uncured concrete, followed by molding.

[Uses of composition]

When the composition according to the present disclosure contains a resin or a ceramic, the composition is useful as a structural material, a conductive material, a heat management material, or an antistatic material.

When the composition according to the present disclosure contains concrete, the composition is useful as a building material having improved lightness and durability, or as an energy storage device (impregnated with an electrolyte if necessary).

<Planar assembly>

A planar assembly of the present disclosure includes the multi-walled carbon nanotube assembly of the present disclosure. The content of the multi-walled carbon nanotube assembly of the present disclosure contained in the planar assembly of the present disclosure is typically 1 mass% or more with respect to the total mass of the planar assembly. The planar assembly of the present disclosure may contain other components such as a carbon nanotube assembly having a maximum length of less than 1,000 $\mu$m, in particular, a multi-walled carbon nanotube assembly having a maximum length of less than 1,000 $\mu$m.

[Method for preparing planar assembly]

The method for preparing the planar assembly according to the present disclosure is not limited.

The planar assembly of the present disclosure can be prepared as, for example, a non-woven fabric-shaped planar assembly by dispersing the multi-walled carbon nanotube assembly of the present disclosure, or the multi-walled carbon nanotube assembly of the present disclosure and other components such as a carbon nanotube assembly having a maximum length of less than 1,000 $\mu$m, in particular, a multi-walled carbon nanotube assembly having a maximum length of less than 1,000 $\mu$m, in water or another fluid, and performing filtration one or more times.

In certain embodiments, the planar assembly of the present disclosure is, for example, a film.

The planar assembly of the present disclosure is useful as, for example, a filter, an electromagnetic wave shielding, and pellicle for extreme ultraviolet rays (EUV) .

Examples

Hereinafter, the assembly and the dispersion liquid containing the assembly according to the present disclosure will be described in more detail by way of Examples. The assembly and dispersion liquid of the present disclosure are not limited to Examples below as long as they are within the spirit of the present disclosure.

Unless otherwise specified, "%" means "mass%".

(Example 1)

1. Production of sheet-shaped ULMWCNT assembly 1

A sheet-shaped ULMWCNT assembly 1 was prepared by a floating catalyst method (CVD method) of directly interacting with the self-assembly of a CNT bundle in a gas phase.

First, ferrocene as a metal catalyst precursor containing Fe atoms and thiophene as an accelerator were introduced into a continuous flow of carrier gas in a through flow reactor set at 400°C to 700°C by temperature control. As a carrier gas, a mixed gas of nitrogen and argon was used. The flow rate of the carrier gas was 30,000 sccm (standard cubic centimeters per minute).

By maintaining the temperature of the inside of the through flow reactor in the above-described range, the metal catalyst precursor was formed as a particulate metal catalyst. The region where the metal catalyst is formed is referred to as a first temperature zone.

Next, methane, which is a carbon source, was released into the carrier gas flow. The metal catalyst and the carbon source were supplied to a second temperature zone set at 1,400°C by temperature control, which was located downstream of the first temperature zone. The second temperature zone is maintained at a temperature sufficient to form a carbon nanotube aggregate.

In the second temperature zone, an electric field was generated in the temperature-controlled flow-type reactor, thereby forming an aggregate of ULMWCNT.

The aggregate of ULMWCNT was discharged such that the aggregate was continuously discharged through the outlet of the flow-type reactor set at 100°C to 500°C by temperature control, and sheet-shaped ULMWCNT assemblies were collected by continuous electric discharge.

The obtained sheet-shaped ULMWCNT assembly contains ULMWCNT and MWCNT.

The obtained sheet-shaped ULMWCNT assembly was washed with deionized water for 10 seconds to adjust the content ratio of Fe atoms, thereby obtaining the sheet-shaped ULMWCNT assembly 1.

2. Preparation of dispersion liquid 1

The following materials were mixed, and treated for 1 hour with Ace Homogenizer manufactured by Nippon Seiki Co., Ltd. to perform pre-dispersion, thereby obtaining a pre-dispersion liquid 1. Before the mixing, the sheet-shaped ULMWCNT assembly 1 was cut into small pieces of about 1 cm x 1 cm with scissors so that the sheet-shaped ULMWCNT assembly 1 did not get entangled with the blade of the homogenizer.

(Composition of dispersion liquid)

- Sheet-shaped ULMWCNT assembly 1 obtained as described above 1.1 g
- CARBOXYMETHYL CELLULOSE SODIUM SALT HIGH VISCOSITY (manufactured by MP Biomedicals) 1.65 g
- Pure water 547.2 g

Using, as a wet jet mill, an ultra-high-pressure homogenizer (model number: NAGS100) manufactured by JOKO, main dispersion of the pre-dispersion liquid 1 was performed to obtain a dispersion liquid 1.

Nozzle diameter: 0.22 mm
Pressure: 85 MPa
Number of times: 8
Mode: Circulation mode

3. Evaluation

3-1. Content ratio of ULMWCNT with a maximum length of 1,000 $\mu$m to 30,000 $\mu$m

First, a plurality of SEM photographs (magnification: 5,000 times) of adjacent fields of view of the obtained sheet-shaped ULMWCNT assembly 1 of Example 1 were observed with a focus on 100 MWCNT, and the results showed that the content ratio of ULMWCNT having a maximum length of 1,000 $\mu$m to 30,000 $\mu$m was 75%, and the largest value of the maximum length among the 100 observed MWCNT was 3,500 $\mu$m.

3-2. Content ratio of Fe atoms to total mass of assembly

Using an inductively coupled plasma mass spectrometer (ICP-MS) (manufactured by PerkinElmer, NexION 2000C), the content ratio of Fe atoms contained in the sheet-shaped ULMWCNT assembly 1 of Example 1 was measured. The sheet-shaped ULMWCNT assembly 1 was subjected to low-temperature ashing/acid dissolution as pretreatment, and measurement was performed with the apparatus. The results showed that the content ratio of Fe atoms to the total mass of the sheet-shaped ULMWCNT assembly 1 of Example 1 was 5.6 mass%.

3-3. Rsp value

The dispersion liquid 1 obtained by turning the sheet-shaped ULMWCNT assembly 1 of Example 1 into a dispersion liquid by the above-described method was put in a sample tube, and the relaxation time $T_{2s}$ was measured using a pulse nuclear magnetic resonance (pulse NMR) apparatus (manufactured by Bruker, the minispec mq20) .
Pure water was put in the sample tube, and the relaxation time $T_{2b}$ was measured. The Rsp value was calculated from the following formula.

$$\mathrm{Rsp} \; = \; (T_{2b} \; / \; T_{2s}) \; - \; 1$$

Table 1 shows the results.

3-4. Viscosity

The viscosity of dispersion liquid 1 was obtained from rheometer measurement. Using a viscoelasticity measurement apparatus (manufactured by Anton Paar, MCR 302), the shear rate dependency of viscosity was evaluated under the following measurement conditions.

Measurement fixture: Cone plate
Measurement mode: Rotation mode
Shear rate: 0.01 s$^{-1}$ to 1,000 s$^{-1}$
Temperature: 25°C

From the obtained data, the viscosity at the following shear rates was read.

$$\text{Shear rate} = 1 \text{ s}^{-1}$$

$$\text{Shear rate} = 100 \text{ s}^{-1}$$

Table 1 shows the results.

3-5. Volume resistivity

The sheet-shaped ULMWCNT assembly 1 of Example 1 was pulverized by a freeze-pulverization method. Using a Loresta apparatus (product name: Powder Resistivity Measurement System MCP-PD51, Low Resistivity Meter Loresta-GP, Powder Low Resistivity Probe MCP-PD511 (a constant current application-type four-probe method), all manufactured by Nittoseiko Analytech Co., Ltd.), the pulverized sheet-shaped ULMWCNT assembly 1 was introduced into a powder resistivity measurement probe unit, and pressed at 5 kN with an accompanying hydraulic pump. After attainment of a target load, the volume resistivity ($\Omega \cdot$cm) was measured.
The results showed that the volume resistivity was $9.2 \times 10^{-3}$ $\Omega \cdot$m at 5 kN.

3-6. Tensile strength

The sheet-shaped ULMWCNT assembly 1 of Example 1 was cut into 5 mm $\times$ 100 mm to obtain a measurement sample, which was fixed to a gripping part of a tensile tester (manufactured by Shimadzu Corporation, Autograph AG-IS), and a tensile test was conducted at a tension rate of 1 mm/min.
The results showed that the tensile strength was 11.3 MPa.

(Example 2)

1. Production of fiber-shaped ULMWCNT assembly 2

A fiber-shaped ULMWCNT assembly 2 was prepared by the floating catalyst method (CVD method) of directly interacting with the self-assembly of a CNT bundle in a gas phase, as in the case of the sheet-shaped ULMWCNT assembly 1.
First, ferrocene as a metal catalyst precursor containing Fe atoms and thiophene as an accelerator were introduced into a continuous flow of carrier gas in a through flow reactor set at 400°C to 700°C by temperature control. As a carrier gas, a mixed gas of nitrogen and argon was used. The flow rate of the carrier gas was 30,000 sccm.
By maintaining the temperature of the inside of the through flow reactor in the above-described range, the metal catalyst precursor was formed as a particulate metal catalyst. The region where the metal catalyst is formed is referred to as a first temperature zone.
Next, methane, which is a carbon source, was released into the carrier gas flow. The metal catalyst and the carbon source were supplied to a second temperature zone set at 1,400°C by temperature control, which was located downstream of the first temperature zone. The second temperature zone is maintained at a temperature sufficient to form a carbon nanotube aggregate.
In the second temperature zone, an electric field was generated in the temperature-controlled flow-type reactor, thereby forming an aggregate of fiber-shaped ULMWCNT.
The carbon nanotube aggregate was discharged such that the aggregate was continuously discharged through the outlet of the flow-type reactor set at 100°C to 500°C by temperature control, and fiber-shaped ULMWCNT assemblies were collected by continuous electric discharge.
The obtained fiber-shaped ULMWCNT assembly contains ULMWCNT and MWCNT. The obtained fiber-shaped ULMWCNT assembly was washed with deionized water for 10 seconds to adjust the content ratio of Fe atoms, thereby obtaining the fiber-shaped ULMWCNT assembly 2.

2. Preparation of dispersion liquid 2

Using the obtained fiber-shaped ULMWCNT assembly 2, a dispersion liquid 2 was obtained in the same manner as in Example 1. Before the mixing, the fiber-shaped ULMWCNT assembly 2 was cut to a length of about 1 cm with scissors so that the fiber-shaped ULMWCNT assembly 2 did not get entangled with the blade of the homogenizer.

3. Evaluation

Evaluation was performed in the same manner as in Example 1 on the fiber-shaped ULMWCNT assembly 2 and the dispersion liquid 2 of Example 2 except that in the measurement of tensile strength, the fiber-shaped ULMWCNT assembly 2 of Example 2 was cut to a length of 100 mm, and fixed to the gripping part of a tensile tester (manufactured by Shimadzu Corporation, Autograph AG-IS), and a tensile test was conducted at a tension rate of 1 mm/min using a thin wire gripping tool (manufactured by Shimadzu Corporation).
Table 1 shows the results.

(Comparative Example 1)

1. Production of sheet-shaped ULMWCNT assembly 3

The sheet-shaped ULMWCNT assembly collected in Example 1 was placed in a polytetrafluoroethylene (PTFE) tray containing hydrochloric acid (manufactured by FUJIFILM Wako Pure Chemical Corporation, special grade reagent) for 24 hours. Thereafter, the sheet-shaped ULMWCNT assembly was taken out from the tray, and washed with deionized water until the pH of the washing water became 7, thereby obtaining a sheet-shaped ULMWCNT assembly 3.

2. Preparation of dispersion liquid 3

Using the obtained sheet-shaped ULMWCNT assembly 3 of Comparative Example 1, a dispersion liquid 3 was obtained in the same manner as in Example 1.

3. Evaluation

Evaluation was performed in the same manner as in Example 1 on the sheet-shaped ULMWCNT assembly 3 and the dispersion liquid 3 of Comparative Example 1.
Table 1 shows the results.
Table 1 shows the results.

(Comparative Example 2)

1. Preparation of powdered MWCNT assembly 1

As a powdered MWCNT assembly 1, "multi-walled carbon nanotubes" (catalog number: FT7000, manufactured by Cnano Ltd.) were prepared.

2. Preparation of dispersion liquid 4

Using powdered MWCNT 1 of Comparative Example 2, a dispersion liquid 4 was obtained in the same manner as in Example 1.

3. Evaluation

Evaluation was performed in the same manner as in Example 1 on the powdered MWCNT assembly 1 and the dispersion liquid 4 of Comparative Example 2 except that in the measurement of tensile strength, the dispersion liquid 4 was poured onto a slide glass-shaped silicon plate of 22 mm × 75 mm × 3 mm (manufactured by DOSAKA EM CO., LTD., #08-1044), and dried by heating to 100°C to obtain a measurement sample, which was fixed to the gripping part of a tensile tester (manufactured by Shimadzu Corporation, Autograph AG-IS), a tensile test was conducted at a tension rate of 1 mm/min.
Table 1 shows the results.

(Comparative Example 3)

1. Preparation of powdered MWCNT assembly 2

As a powdered MWCNT assembly 2, "multi-walled carbon nanotubes" (catalog number: FT6120, manufactured by Cnano Ltd.) were prepared.

2. Preparation of dispersion liquid 5

Using the powdered MWCNT assembly 2 of Comparative Example 3, a dispersion liquid 5 was obtained in the same manner as in Example 1.

3. Evaluation

Evaluation was performed in the same manner as in Example 1 on the powdered MWCNT assembly 2 and the dispersion liquid 5 of Comparative Example 3 except that in the measurement of tensile strength, the dispersion liquid 5 was poured onto a slide glass-shaped silicon plate of 22 mm × 75 mm × 3 mm (manufactured by DOSAKA EM CO., LTD., #08-1044), and dried by heating to 100°C to obtain a measurement sample, which was fixed to the gripping part of a tensile tester (manufactured by Shimadzu Corporation, Autograph AG-IS), a tensile test was conducted at a tension rate of 1 mm/min.
Table 1 shows the results.

(Comparative Example 4)

1. Preparation of powdered SWCNT assembly 1

As a powdered SWCNT assembly 1, "single-walled carbon nanotubes" (catalog number: TUBALL, manufactured by OCSiAl) were prepared.

2. Preparation of dispersion liquid 6

As a dispersion liquid of powdered SWCNT assembly 1 of Comparative Example 4, a dispersion liquid 6 [product name: TUBALL(TM) BATT $H_2O$, single-walled carbon nanotube aqueous solution, manufactured by OCSiAl] was used. The concentration of CNT was adjusted to 0.2 mass%.

3. Evaluation

Evaluation was performed in the same manner as in Example 1 on the powdered SWCNT assembly 1 and the dispersion liquid 6 of Comparative Example 4 except that in the measurement of tensile strength, the dispersion liquid 6 was poured onto a slide glass-shaped silicon plate of 22 mm × 75 mm × 3 mm (manufactured by DOSAKA EM CO., LTD., #08-1044), and dried by heating at 100°C to obtain a measurement sample, which was fixed to the gripping part of a tensile tester (manufactured by Shimadzu Corporation, Autograph AG-IS), a tensile test was conducted at a tension rate of 1 mm/min.
Table 1 shows the results.

[Table 1]

| | ULMWCNT content ratio | Maximum value of maximum length of ULMWCNT ($\mu$m) | Shape of assembly | Conductivity of assembly ($\Omega\cdot$cm) | Fe atom content ratio (mass%) | Rsp value | Viscosity (Pa·s) | | Tensile strength (MPa) |
|---|---|---|---|---|---|---|---|---|---|
| | | | | | | | Shear rate 1s$^{-1}$ | Shear rate 100s$^{-1}$ | |
| Example 1 | 75% | 3500 | Sheet shape | $9.2\times10^{-3}$ | 5.6 | 4320 | 4.210 | 0.0796 | 11.3 |
| Example 2 | 75% | 4000 | Fiber shape | $9.4\times10^{-3}$ | 4.0 | 3174 | 2.896 | 0.0731 | 19.7 |
| Comparative Example 1 | 75% | 3500 | Sheet shape | $9.2\times10^{-3}$ | 0.3 | 153 | 4.896 | 0.1152 | 16.9 |
| Comparative Example 2 | 0% | 20 | Powdered | $4.8\times10^{-2}$ | 1.7 | 29 | 0.017 | 0.0087 | 6.9 |
| Comparative Example 3 | 0% | 250 | Powdered | $3.0\times10^{-2}$ | 0.002 | 399 | 0.007 | 0.0061 | 8.2 |
| Comparative Example 4 | 0% | 100 | Powdered | $9.8\times10^{-3}$ | 11.0 | 170 | 15.457 | 0.3886 | 4.0 |

22

As shown in Table 1, the sheet-shaped ULMWCNT assembly 1 (Example 1) and the fiber-shaped ULMWCNT assembly 2 (Example 2) from Examples have a property of being easily entangled with each other because of an ULMWCNT assembly, and hence high conductivity, and have an Fe atom content ratio of 0.5 mass% or more and less than 10 mass%. Therefore, the obtained dispersion liquid had a high Rsp value, good affinity for the dispersion medium was exhibited, and the value of viscosity was acceptable from a practical point of view. From this, it can be seen that the assemblies of Examples have high conductivity and good dispersibility in the dispersion medium.

On the other hand, the sheet-shaped ULMWCNT assembly 3 having an Fe atom content ratio of less than 0.5 mass% (Comparative Example 1) has a property of being easily entangled with each other because of an ULMWCNT assembly, and hence high conductivity. However, the contact between a plurality of ULMWCNT is not moderately inhibited by Fe atoms, and agglomeration is not suppressed. Therefore, the Rsp value of the obtained dispersion liquid is low, affinity for the dispersion medium is insufficient, and the value of viscosity particularly at a shear rate of $100 \text{ s}^{-1}$ is high. It can be seen that the sheet-shaped ULMWCNT assembly 3 is not acceptable from a practical point of view. Therefore, it can be seen that the sheet-shaped ULMWCNT assembly 3 is inferior in dispersibility in the dispersion medium to the assemblies of Examples.

The powdered MWCNT assembly 1 (Comparative Example 2) and the powdered MWCNT assembly 2 (Comparative Example 3) from Comparative Examples have a small maximum length and a poor property of being entangled with each other, and therefore can be seen to have low conductivity. Because of the poor property of being entangled with each other, agglomeration of MWCNT is unlikely to occur, and regardless of the content ratio of Fe atoms, the Rsp value of the obtained dispersion liquid is low, affinity for the dispersion medium is insufficient, and the viscosity is low. It can be seen that the powdered MWCNT assemblies 1 and 2 are not acceptable from a practical point of view.

It can be seen that the powdered SWCNT assembly 1 (Comparative Example 4) from Comparative Example has higher conductivity over MWCNT because of SWCNT. However, SWCNT is more heavily agglomerated as compared to MWCNT, and the agglomeration of SWCNT is not suppressed even when the content ratio of Fe atoms is 10.0 mass% or more. Therefore, the Rsp value of the obtained dispersion liquid is low, affinity for the dispersion medium is insufficient, and the value of viscosity is high. It can be seen that the powdered SWCNT assembly 1 is not acceptable from a practical point of view.

**Claims**

1.   A multi-walled carbon nanotube assembly comprising

multi-walled carbon nanotubes having a maximum length of 1,000 $\mu$m to 30,000 $\mu$m, and
Fe atoms,
wherein a content ratio of Fe atoms to a total mass of the assembly is 0.5 mass% or more and less than 10 mass%.

2.   The multi-walled carbon nanotube assembly according to claim 1, which is a conductive auxiliary agent.

3.   A multi-walled carbon nanotube dispersion liquid comprising the multi-walled carbon nanotube assembly according to claim 1 or 2, and a dispersion medium.

4.   A conductive material comprising the multi-walled carbon nanotube assembly according to claim 1 or 2.

5.   The multi-walled carbon nanotube dispersion liquid according to claim 3, which is an ink composition for formation of a lithium battery negative electrode.

6.   An electrode comprising an electrode active material, and the conductive material according to claim 4.

7.   A secondary battery comprising the electrode according to claim 6.

8.   A composition comprising the multi-walled carbon nanotube assembly according to claim 1 or 2, and at least one selected from the group consisting of a resin, a ceramic, and concrete.

9.   A multi-walled carbon nanotube assembly comprising

multi-walled carbon nanotubes having a tensile strength of 10 MPa to 100 MPa, and
Fe atoms,
wherein a content ratio of Fe atoms to a total mass of the assembly is 0.5 mass% or more and less than 10 mass%.

10. The multi-walled carbon nanotube assembly according to claim 9, which is a conductive auxiliary agent.

11. A multi-walled carbon nanotube dispersion liquid comprising the multi-walled carbon nanotube assembly according to claim 9 or 10, and a dispersion medium.

12. A conductive material comprising the multi-walled carbon nanotube assembly according to claim 9 or 10.

13. The multi-walled carbon nanotube dispersion liquid according to claim 11, which is an ink composition for formation of a lithium battery negative electrode.

14. An electrode comprising an electrode active material, and the conductive material according to claim 12.

15. A secondary battery comprising the electrode according to claim 14.

16. A composition comprising the multi-walled carbon nanotube assembly according to claim 9 or 10, and at least one selected from the group consisting of a resin, a ceramic, and concrete.

17. A composition comprising: a multi-walled carbon nanotube assembly comprising multi-walled carbon nanotubes and Fe atoms, wherein a content ratio of Fe atoms to a total mass of the assembly is 0.5 mass% or more and less than 10 mass%; and at least one selected from the group consisting of a dispersion medium, a resin, a ceramic, and concrete.

18. A multi-walled carbon nanotube dispersion liquid comprising multi-walled carbon nanotubes having a tensile strength of 10 MPa to 100 MPa, and a dispersion medium.

19. A planar assembly comprising the multi-walled carbon nanotube assembly according to claim 1, 2, 9 or 10.

20. A filter comprising the planar assembly according to claim 19.

21. An electromagnetic wave shielding comprising the planar assembly according to claim 19.

22. A pellicle for extreme ultraviolet rays comprising the planar assembly according to claim 19.

Fig. 1

## INTERNATIONAL SEARCH REPORT

| International application No. |
| --- |
| **PCT/JP2024/021495** |

**A. CLASSIFICATION OF SUBJECT MATTER**

*C01B 32/158*(2017.01)i; *C01B 32/16*(2017.01)i; *C01B 32/174*(2017.01)i; *H01M 4/13*(2010.01)i; *H01M 4/62*(2006.01)i
FI:  C01B32/158; C01B32/16; C01B32/174; H01M4/13; H01M4/62 Z

According to International Patent Classification (IPC) or to both national classification and IPC

**B. FIELDS SEARCHED**

Minimum documentation searched (classification system followed by classification symbols)

C01B32/158; C01B32/16; C01B32/174; H01M4/13; H01M4/62

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JST7580/JSTChina (JDreamIII)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2010-196012 A (TOYO INK MANUFACTURING CO., LTD.) 09 September 2010 (2010-09-09) <br> paragraphs [0045]-[0046] | 17 |
| A | | 1-16, 18-22 |
| X | JP 2020-164383 A (THE FURUKAWA ELECTRIC CO., LTD.) 08 October 2020 (2020-10-08) <br> paragraphs [0019], [0040]-[0060], table 1 | 18 |
| A | | 1-17, 19-22 |
| X | US 2006/0029537 A1 (ZHANG X.) 09 February 2006 (2006-02-09) <br> claims, paragraph [0050] | 18 |
| A | | 1-17, 19-22 |
| A | JP 2020-515497 A (HYDRO-QUEBEC) 28 May 2020 (2020-05-28) <br> paragraph [0110] | 17 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **15 August 2024** | **03 September 2024** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

**INTERNATIONAL SEARCH REPORT**

| International application No. |
| --- |
| **PCT/JP2024/021495** |

**C.     DOCUMENTS CONSIDERED TO BE RELEVANT**

| Category* | Citation of document, with indication, where appropriate, of the relevant passages | Relevant to claim No. |
| --- | --- | --- |
| A | JP 2015-007304 A (CAMBRIDGE ENTERPRISE LIMITED) 15 January 2015 (2015-01-15) | 1-22 |
| A | WO 2020/171047 A1 (SUMITOMO ELECTRIC INDUSTRIES, LTD.) 27 August 2020 (2020-08-27) | 1-22 |

Form PCT/ISA/210 (second sheet) (July 2022)

## INTERNATIONAL SEARCH REPORT
### Information on patent family members

International application No.

**PCT/JP2024/021495**

| Patent document cited in search report | | | Publication date (day/month/year) | Patent family member(s) | | | Publication date (day/month/year) |
|---|---|---|---|---|---|---|---|
| JP | 2010-196012 | A | 09 September 2010 | (Family: none) | | | |
| JP | 2020-164383 | A | 08 October 2020 | (Family: none) | | | |
| US | 2006/0029537 | A1 | 09 February 2006 | (Family: none) | | | |
| JP | 2020-515497 | A | 28 May 2020 | US | 2021/0107791 | A1 | |
| | | | | paragraphs [0125]-[0128] | | | |
| | | | | EP | 3601161 | A2 | |
| | | | | KR | 10-2019-0135032 | A | |
| | | | | CN | 110662715 | A | |
| JP | 2015-007304 | A | 15 January 2015 | US | 2005/0006801 | A1 | |
| | | | | EP | 2615193 | A1 | |
| | | | | KR | 10-2012-0073343 | A | |
| WO | 2020/171047 | A1 | 27 August 2020 | US | 2022/0153585 | A1 | |
| | | | | CN | 113490638 | A | |

Form PCT/ISA/210 (patent family annex) (July 2022)

28

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020138379 A

- JP 2016102047 A